# EUROPEAN PATENT APPLICATION

(11) **EP 3 360 624 A1**
(43) Date of publication of application: **15.08.2018**
(21) Application number: 18155388.4
(22) Date of filing: 06.02.2018
(51) Int. Cl.: B22D 17/20

(54) **AXISYMMETIC SINGLE CRYSTAL SHOT TUBE FOR HIGH TEMPERATURE DIE CASTING**

(30) Priority: 08.02.2017 US 201715427897
(71) Applicant: United Technologies Corporation, Farmington, CT 06032 (US)
(72) Inventor: MARCIN, John Joseph, Marlborough, CT Connecticut 06447 (US); SHAH, Dilip M., Glastonbury, CT Connecticut 06033 (US)
(74) Representative: Dehns

(57) **Abstract**

A die casting system (10) includes a die (12) including a plurality of die components that define a die cavity (20), a single crystal shot tube (24) in fluid communication with the die cavity (20), and a shot tube plunger tip (28) moveable within the shot tube (24) to communicate a charge of a molten or semi-molten material into the die cavity (20). The system further includes a vacuum chamber (40) that applies a vacuum to render a die casting process wherein at least a portion of the die (12) is positioned within the vacuum chamber (40).

## Description

### BACKGROUND

This disclosure relates generally to die casting systems, and more particularly to a die casting system with a thermally stable shot tube for high temperature die casting.

Casting is a known technique used to yield near net-shaped components. For example, investment casting is often used in the gas turbine engine industry to manufacture components having relatively complex geometries, such as blades and vanes. A component can be investment cast by pouring molten metal into a ceramic shell having a cavity in the shape of the component to be cast. Generally, the shape of the component to be cast is derived from a wax pattern or a rapid prototype pattern that defines the shape of the component. The investment casting process is capital intensive, requires a significant amount of manual labor, and can be time intensive.

Die casting offers another known casting technique. Die casting involves injecting molten metal directly into a reusable die to yield a near net-shaped component. The tooling of the die cast system, including the die, the shot tube, and the shot tube plunger tip are subject to relatively high thermal loads and stresses during the die casting process.

### SUMMARY

In an embodiment, a die casting system includes a die including a plurality of die components that define a die cavity, a single crystal shot tube in fluid communication with the die cavity, and a shot tube plunger tip moveable within the shot tube to communicate a charge of a molten or semi-molten material into the die cavity. The system further includes a vacuum chamber that applies a vacuum to render a die casting process wherein at least a portion of the die is positioned within the vacuum chamber.

In another embodiment, a die casting system may include a die that defines a die cavity, a single crystal shot tube in fluid communication with the die cavity, and a shot tube plunger tip moveable within the shot tube. The system may also include a melting system positioned adjacent to the die and a vacuum chamber that applies a vacuum to render a vacuum die casting process wherein at least a portion of the die is positioned within the vacuum chamber.

In another embodiment, an injection unit for a die casting system may include an alloy shot tube capable of containing a molten or semi-molten charge, a shot tube plunger tip moveable within the shot tube to communicate the molten charge to a die cavity, and a melting unit adjacent the shot tube.

### BRIEF DESCRIPTION OF THE DRAWINGS

FIG. 1 is a schematic illustration of a die casting system.
FIG. 2 is a schematic illustration showing details of the injection mechanism of Fig 1.
FIG. 3A is a schematic illustration of an oriented single crystal tube.
FIG. 3B is a schematic illustration of a deformation processed single crystal shot tube blank for machining.
FIG. 4 is a flow chart of a method to fabricate an oriented single crystal shot tube according to an embodiment of the present disclosure.

### DETAILED DESCRIPTION

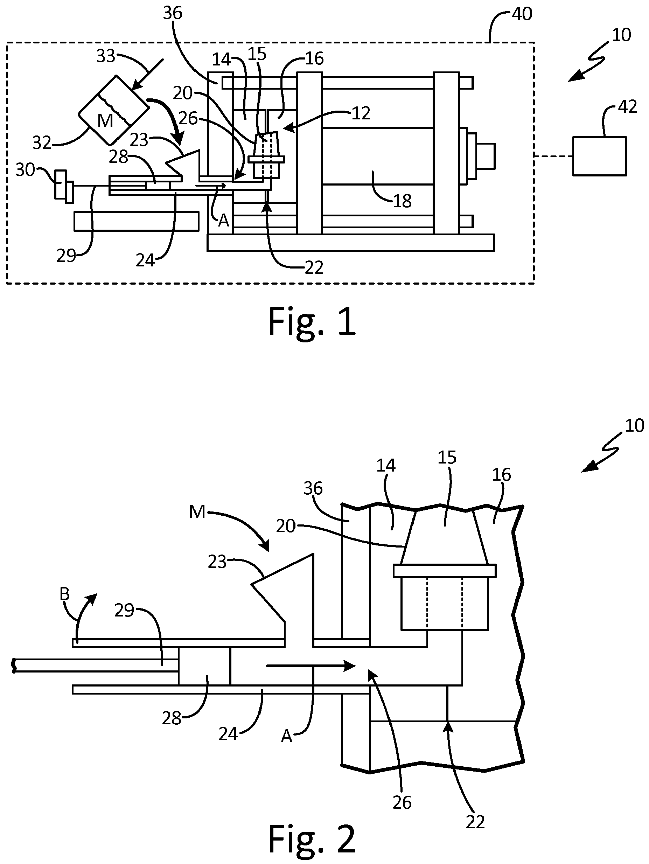

FIG. 1 illustrates an example die casting system 10 including a reusable die 12 having a plurality of die elements 14 and 16 that function to cast a component. Although two die elements 14 and 16 are depicted in FIG. 1, it should be understood that the die 12 could include a greater or fewer number of die elements, as well as other parts and configurations.

The die 12 is assembled by positioning the die elements 14 and 16 together and holding the die elements 14 and 16 at a desired position via a mechanism 18. The mechanism 18 could include a clamping mechanism of an appropriate hydraulic, pneumatic, electromechanical, and/or other configurations. The mechanism 18 also separates the die elements 14 and 16 subsequent to casting.

The die elements 14 and 16 define internal surfaces 22 that cooperate to define a die cavity 20. A shot tube 24 is in fluid communication with the die cavity 20 via one or more ports 26 located in the die element 14, the die element 16 or both. A shot tube plunger tip 28 is received within the shot tube 24 and is moveable between a retracted and an injected position (in the direction of arrow A) within the shot tube 24 by a mechanism 30. A shot rod 29 extends between the mechanism 30 and the shot tube plunger tip 28. The mechanism 30 could include a hydraulic assembly or other suitable system including, but not limited to, pneumatic, electromechanical, hydraulic, and/or any combination of the systems.

The shot tube 24 is positioned in plate 36 to receive a charge of material M from a melting unit 32 such as a crucible, for example. The melting unit 32 can utilize any known technique for melting an ingot of metallic material to prepare the charge of material M for delivery to the shot tube 24, including but not limited to, vacuum induction melting, electron beam melting, induction skull melting, and resistance melting. In an embodiment, arrow 33 in Fig. 1 indicates electron beam melting. The charge of material M is melted into molten or semi-molten metal in the melting unit 32 at a location that is separate from the shot tube 24 and the die cavity 20. In this example, the melting unit 32 is positioned in close proximity to the shot tube 24 to reduce the required transfer distance between the charge of material M and the shot tube 24.

The charge of material M is transferred from the melting unit 32 to the shot tube 24 in a known manner, such as pouring the charge of material M into a pour hole 23 in the shot tube 24, for example. A sufficient amount of molten or semi-molten metal is poured into shot tube 24 to fill the die cavity 20. The shot tube plunger tip 28 is actuated to inject the charge of material M under pressure from the shot tube 24 into the die cavity 20 to cast a component 15. Although a single component 15 is depicted, the die casting system 10 could be configured to cast multiple components in a single shot.

At least a portion of the die casting system 10 can be positioned within a vacuum chamber 40 that includes a vacuum source 42. In the illustrated embodiment, the entirety of the die casting system 10 is positioned within vacuum chamber 40. A vacuum is applied in the vacuum chamber 40 via the vacuum source 42 to render a vacuum die casting process. The vacuum chamber 40 provides a non-reactive environment for the die casting system 10 and reduces reaction, contamination, and/or other conditions that could detrimentally affect the quality of the die cast component, such as excess porosity in the cast component resulting from exposure to air.

In one example, the vacuum chamber 40 is maintained at a pressure of 0.66 Pa (5 x 10-3 Torr) and 0.000133 Pa (1 x 10-6 Torr), although other pressures are contemplated. The actual pressure of the vacuum chamber 40 will vary based on the type of component 15 cast, among other conditions and factors. In the illustrated example, each of the melting unit 32, the shot tube 24 and the die 12 are positioned within the vacuum chamber 40 during the die casting process such that the melting, injecting and solidifying of the charge of material M are each performed under vacuum. In another example, the vacuum chamber 40 is vacuum filled with an inert gas, such as argon, for example.

The example die casting system 10 depicted by FIG. 1 is illustrative only and could include a greater or fewer number of sections, parts, and/or components. This disclosure extends to all forms of die casting, including but not limited to, horizontal, vertical, inclined, or other die casting configurations.

Problems can arise when systems such as die casting system 10 are employed to produce high temperature superalloy aerospace components. Since the high temperature molten or semi-molten alloys used for casting these components severely tax the reliability and lifetime of a number of critical internal die casting system components, arguments for the use of die casting based on high throughput and part quality are difficult if long production runs cannot be guaranteed. This is particularly an issue for the shot tube 24. The shot tube 24 must remain dimensionally accurate for shot tube plunger tip (piston) 28 to have proper clearance and be able to move while being exposed to the high temperature metal poured into it before and after metal injection. The shot tube typically fails from thermal mechanical fatigue induced by the rapid introduction and expulsion of metal through the casting cycle.

A schematic illustration of the metal injection mechanism of FIG. 1 is shown in FIG. 2 to illustrate another issue involving the shot tube 24. The shot tube 24 is fixedly mounted on one end in plate 36 and is cantilevered therefrom. When molten metal M is poured in shot tube 24, the bottom has a tendency to expand such that the shot tube 24 has a tendency to deflect upward, as indicated by arrow B. If the upward deflection is sufficient, piston 28 will jam inside shot tube 24, preventing the casting operation from being completed. Therefore, the shot tube 24 is made to have minimum axial deflection and a relatively high thermal mechanical fatigue resistance.

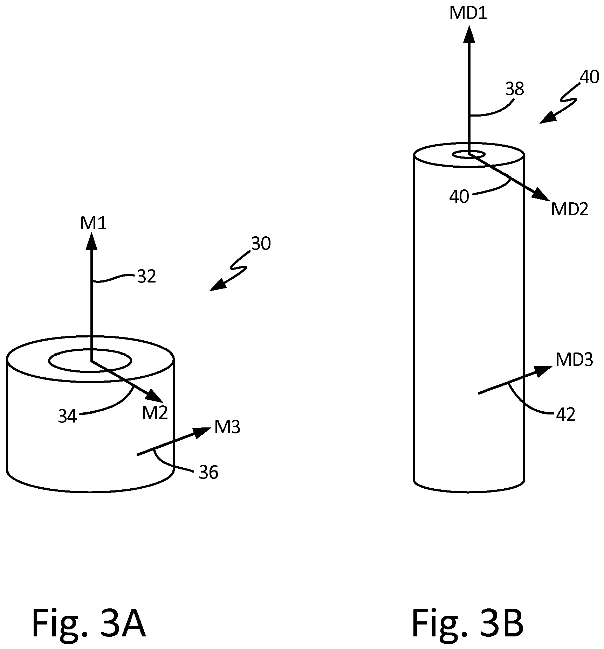

More specifically, the shot tube 24 can be made of a nickel base superalloy in the form of an oriented single crystal with a <110> or <111> axial orientation. A schematic illustration of a cast nickel base superalloy single crystal tube 30 with a <110> axial orientation is shown in FIG. 3A. Arrow 32 indicates the <110> axial orientation, arrow 34 indicates a <100> radial orientation and arrow 36 indicates a <100> tangential orientation. The mechanical properties of nickel base superalloy single crystal tube 30 are highly anisotropic. Young's modulus M1 in the <110> axial orientation in an example alloy of the present disclosure discussed below is about 207 GPa (30 MPsi). The radial <100> direction is indicated by arrow 34. Young's modulus M2 in the radial direction is considerably less and is about 138 GPa (20 MPsi). The <100> circumferential direction is indicated by arrow 36. The <100> Young's modulus M3 in the circumferential direction is also about 138 GPa (20 MPsi).

In order to form a shot tube from as cast oriented single crystal 30, crystal 30 is reduced in diameter and extended in length by deformation processing at an elevated temperature. Deformation processed shot tube blank 40 is shown in FIG. 3B. Shot tube blank 40 has retained the preferred <110> axial orientation of starting single crystal 30. Deformation processing has created a highly worked subgrain microstructure in the shot tube blank that has altered the anisotropy of the mechanical properties. The previous <110> axial orientation has been retained in the deformation processed shot tube blank 40. Axial Young's modulus MD1 (indicated by arrow 38) is about 207 GPa (30 MPsi). The radial Young's modulus MD2 (indicated by arrow 40), as a result of the refined microstructure is about 207 GPa (30 MPsi). The tangential Young's modulus MD3 (indicated by arrow 42) is still lower than the radial modulus and is about 138 GPa (20 MPsi).

The anisotropic mechanical properties in deformation processed shot tube 40 result in improved performance and lifespan. During exposure to high temperature molten metal, axial expansion is restricted by the high axial Young's modulus in shot tube 40 leading to minimal deflection and resulting thermal mechanical fatigue resistance. In addition, deformation in the <100> hoop direction is higher thereby restricting the formation of longitudinal hoop stress fatigue fractures.

High temperature alloys suitable for die casting include, but are not limited to, nickel based, iron based alloys and mixtures thereof. Nickel base alloys suitable for die casting application of the present disclosure include, but are not limited to, PWA 1404, PWA 1429, PWA 1480, PWA 1484, and CMX4.

An integrated computational process model of the die casting system of the present disclosure was created combining fluid flow, heat transfer, thermal dynamics, and metal solidification to simulate the process and predict optimum combinations of component design, component material, and process parameters. This model indicated that extending the life of the shot tube component by incorporating a deformation processed oriented nickel base superalloy single crystal would be most beneficial. Thermal fatigue studies of the model indicated shot tube life exceeding 1000 shots. It is possible that high temperature metallic parts can be fabricated at higher rates and lower cost (25-75%) than alternative casting and forging processes and cost effective production can be achieved.

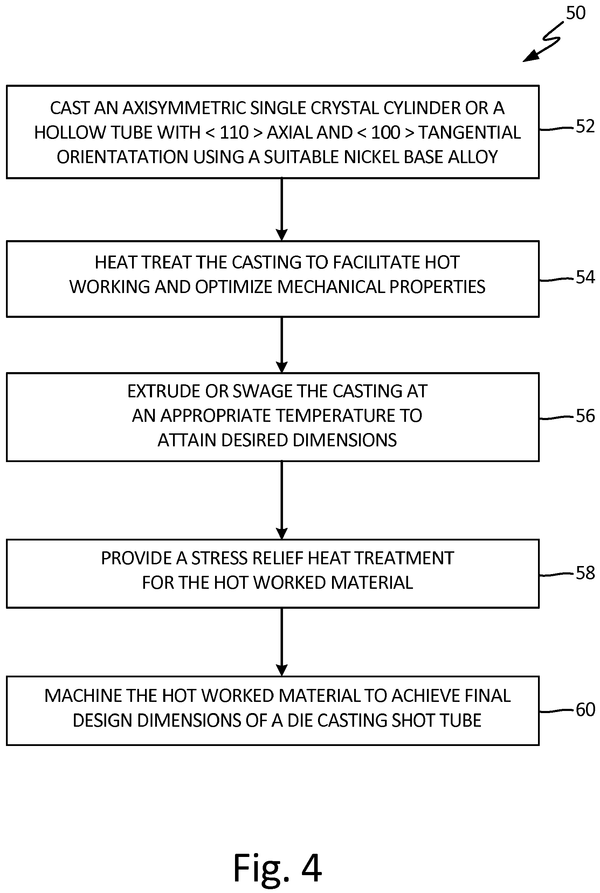

A method of fabricating a shot tube according to an embodiment of the present disclosure is shown in FIG. 4. Method 50 begins with casting an axisymmetric single crystal cylinder or a hollow tube with a <110> axial and <100> tangential orientation (step 52). A preferred alloy is a nickel base alloy. Preferred nickel base alloys include PWA 1404, PWA 1429, PWA 1480, PWA 1484, and CMX4. In the next step, the casting is heat treated to enhance deformation processing and to optimize mechanical properties (step 54). An example heat treatment may be 30 minutes to 4 hours at 2400°F (1316°C) air cool if extensive extrusion is not required. For long tubes requiring extensive extrusion, a 30 minute to 4 hours at 2400°F (1316°C), slow cool at 0.3°F per minute to 2000°F (1093°C), furnace cool. In the next step the casting is hot worked to a reduced diameter and extended length (step 56). Appropriate temperatures for hot working are below a recrystallization temperature of about 2100°F (1150°C). Hot working is preferably by swaging or extrusion. The deformation process shot tube blank is then given a stress relief anneal (step 58). An example stress relief anneal is about 4-8 hours between 1975°F (1080°C) and 2100°F (1150°C) followed by a precipitation treatment of 32 hours at 1600°F (871°C). Finally, the shot tube blank is machined to final dimensions (step 60). Procedures appropriate for this process include turning, diamond grinding, and other procedures known in the art.

### Discussion of Possible Embodiments

The following are non-exclusive descriptions of possible embodiment of the present invention.

A die casting system may include a die including a plurality of die components that define a die cavity; a single crystal shot tube in fluid communication with the die cavity and operable to deliver a charge of material to the die cavity; a shot tube plunger tip moveable within the shot tube to inject the charge of material into the die; a melting unit positioned relative to the die to communicate the charge of material to the shot tube; and a vacuum chamber that applies a vacuum to render a vacuum die casting process, wherein at least a portion of the die is positioned within the vacuum chamber.

The system of the preceding paragraph can optionally include, additionally and/or alternatively, any one or more of the following features, configurations, and/or additional components:
The single crystal may be an oriented single crystal.

The orientation may be a <110> or a <111> axial orientation.

The shot tube may be formed from a nickel based, cobalt based, iron based alloys or mixtures thereof.

The alloy maybe PWA 1404, PWA 1429, PWA 1480, PWA 1484 and CMX4.

The vacuum may be maintained at a pressure range of 0.6666 to 0.000133 PA (5x10-3 to 1x10-6 Torr).

The melting unit may include at least one electron beam melting gun.

The material may be a nickel based, iron based alloy or mixtures thereof.

A die casting system may include: a die that defines a die cavity; a single crystal shot tube in fluid communication with the die cavity; a shot tube plunger tip moveable within the shot tube; a melting system positioned adjacent to the die; and a vacuum chamber that applies a vacuum to render a vacuum die casting process, wherein at least a portion of the die is positioned within the vacuum chamber.

The system of the preceding paragraph can optionally include, additionally and/or alternatively, any one of more of the following features, configurations, and/or additional component:
The single crystal shot tube may be an oriented single crystal.

The orientation may be a <110> or a <111> axial orientation.

The shot tube may be formed from nickel based, iron based alloys or mixtures thereof.

The alloys maybe PWA 1404, PWA 1429, PWA 1480, PWA 1484 and CMX4.

The vacuum may be maintained at a pressure in the range of 0.6666 to 0.000133 PA (5x10-3 to 1x10-6 Torr).

The melting unit may include at least one electron beam melting gun.

An injection unit for a die casting system may include: an alloy shot tube capable of containing a molten or semi-molten charge; a shot tube plunger tip moveable within the shot tube to communicate the molten or semi-molten charge to a die cavity; and a melting unit adjacent the shot tube.

The system of the preceding paragraph can optionally include, additionally and/or alternatively, any one or more of the following features, configurations and/or additional components:
The shot tube may be a single crystal.

The single crystal may be an oriented single crystal.

The orientation may be a <110> or a <111> axial orientation.

The melting unit may contain at least one electron beam melting gun.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A die casting system, comprising:
a die including a plurality of die components that define a die cavity;
a single crystal shot tube in fluid communication with the die cavity and operable to deliver a charge of material to the die cavity;
a shot tube plunger tip moveable within the shot tube to inject the charge of material into the die;
a melting unit positioned relative to the die to communicate the charge of material in a molten or semi-molten state to the shot tube; and
a vacuum chamber that applies a vacuum to render a vacuum die casting process, wherein at least a portion of the die is positioned within the vacuum chamber.

2. The system of claim 1, wherein the single crystal comprises an oriented single crystal.

3. The system of claim 1 or claim 2, wherein the material comprises a nickel base, iron base alloy, or mixtures thereof.

4. A die casting system comprising:
a die that defines a die cavity;
a single crystal shot tube in fluid communication with the die cavity;
a shot tube plunger tip moveable within the shot tube;
a melting system positioned adjacent to the die; and
a vacuum chamber that applies a vacuum to render a vacuum die casting process, wherein at least a portion of the die is positioned within the vacuum chamber.

5. The system of claim 4, wherein the single crystal shot tube comprises an oriented single crystal.

6. The system of any preceding claim, wherein the orientation comprises a <110> or <111> axial orientation.

7. The system of any preceding claim, wherein the shot tube is formed from nickel base, iron base alloys, or mixtures thereof.

8. The system of claim 7, wherein the alloy comprises PWA 14047, PWA 1429, PWA 1480, PWA 1484 and CMX4.

9. The system of any preceding claim, wherein the vacuum in maintained at a pressure in the range of 0.6666 to 0.000133 Pa (5x10⁻³ to 1x10⁻⁶ Torr).

10. The system of any preceding claim, wherein the melting unit includes at least one electron beam melting gun.

11. An injection unit for a die casting system, comprising:
an alloy shot tube capable of containing a molten or semi-molten charge;
a shot tube plunger tip moveable within the shot tube to communicate the molten or semi-molten charge to a die cavity; and
a melting unit adjacent the shot tube.

12. The injection unit of claim 11, wherein the shot tube comprises a single crystal.

13. The injection unit of claim 12, wherein the single crystal comprises an oriented single crystal.

14. The injection unit of claim 13, wherein the orientation comprises a <110> or <111> axial orientation.

15. The injection unit of any of claims 11 to 14, wherein the melting unit contains at least one electron beam melting gun.
